# FASCICULE DE BREVET EUROPEEN

(11) **EP 0 738 894 B1**
(45) Date de publication et mention de la délivrance du brevet: **10.12.2003**
(21) Numéro de dépôt: 96810244.2
(22) Date de dépôt: 18.04.1996
(51) Int. Cl.: G01R 15/18, G01R 15/20

(54) **Dispositif capteur de courant à détecteur de champ magnétique**
Stromfühler mit Magnetfelddetektor
Current sensor with magnetic field detector

(30) Priorité: 18.04.1995 CH 111095
(43) Date de publication de la demande: 23.10.1996
(73) Titulaire: LIAISONS ELECTRONIQUES-MECANIQUES LEM S.A., 1228 Plan-les-Ouates (CH)
(72) Inventeur: Etter, Marcel, 1256 Troinex (CH)
(74) Mandataire: Reuteler, Raymond Werner

(56) Documents cités:
- EP-A- 0 392 439
- FR-A- 2 306 450

## Description

La présente invention concerne un dispositif capteur de courant pour la mesure du courant électrique passant dans un conducteur, ce dispositif comportant un circuit magnétique à entrefer agencé pour pouvoir être couplé avec ledit conducteur pour le courant à mesurer, un détecteur de champ magnétique disposé dans l'entrefer de ce circuit, un bobinage monté sur ce circuit magnétique, un premier circuit électrique de mesure comprenant ledit bobinage, des moyens pour faire passer dans ce bobinage, sous la commande du détecteur de champ magnétique, un courant de compensation tendant à annuler le champ produit dans l'entrefer par le courant à mesurer, et des moyens pour fournir un premier signal de mesure fonction dudit courant de compensation.

Des dispositifs de ce type sont utilisés dans de nombreuses applications industrielles et sont décrits, par exemple, dans le brevet suisse No 677.034 ou dans la demande européenne EP 0392 439 A. Ils présentent notamment une grande précision de la mesure. Toutefois, pour la mesure de courants de forte intensité, les ampères-tours à fournir pour la compensation nécessitent un bobinage et un circuit d'alimentation correspondant, ce qui entraîne notamment un volume et un prix de revient relativement importants du capteur et des circuits associés. Or, dans certaines applications, il n'est pas nécessaire de fournir la même précision dans toute la gamme de mesure des courants. L'on peut notamment se contenter d'une précision élevée pour la mesure de courants relativement faibles et d'une précision moindre pour la mesure des courants plus forts.

La présente invention vise à fournir un dispositif capteur de courant qui permette de réduire le volume et le coût du capteur et de son circuit d'alimentation, tout en fournissant une précision élevée pour les courants de la partie inférieure de la gamme de mesure des courants.

A cet effet, le dispositif selon l'invention est caractérisé en ce qu'il comporte un second circuit électrique de mesure agencé pour fournir un second signal de mesure fonction du champ magnétique détecté dans l'entrefer, le premier circuit de mesure étant dimensionné de façon à être saturé électriquement à une valeur du courant de compensation correspondant à un courant à mesurer sensiblement inférieur au courant maximum à mesurer.

Le dispositif selon l'invention comporte, de préférence, des moyens pour additionner les premier et second signaux de mesure, de façon à produire un signal de mesure résultant dont la variation avec le courant à mesurer est continue dans toute la gamme de mesure.

Selon une forme d'exécution particulière, le premier circuit de mesure est commandé par un premier détecteur de champ magnétique présentant une erreur d'offset relativement faible, le second circuit de mesure comprend un second détecteur de champ magnétique présentant une variation de gain relativement faible, et le dispositif comporte des moyens pour annuler le signal de sortie du second circuit de mesure tant que le premier circuit de mesure n'est pas saturé, de façon à compenser l'erreur d'offset du second circuit de mesure, ainsi que des moyens pour maintenir cette compensation dans le second circuit de mesure durant la période durant laquelle le premier circuit de mesure est électriquement saturé.

Les détecteurs de champ magnétique sont de préférence des cellules de Hall.

L'invention sera mieux comprise à la lumière de la description de formes de réalisation particulières, indiquées ci-après à titre d'exemple et illustrées dans le dessin annexé, dans lequel
La Fig. 1 est le schéma électrique d'une première forme d'exécution du capteur selon l'invention;
La Fig. 2 est une vue schématique du circuit magnétique d'un capteur selon la Fig. 1;
La Fig. 3 est un graphique montrant la variation de la précision du présent capteur en fonction du courant;
La Fig. 4 est un graphique montrant la variation de la tension en différents points du circuit de la Fig. 1; et
La Fig. 5 est le schéma électrique d'une autre forme d'exécution d'un capteur selon l'invention.

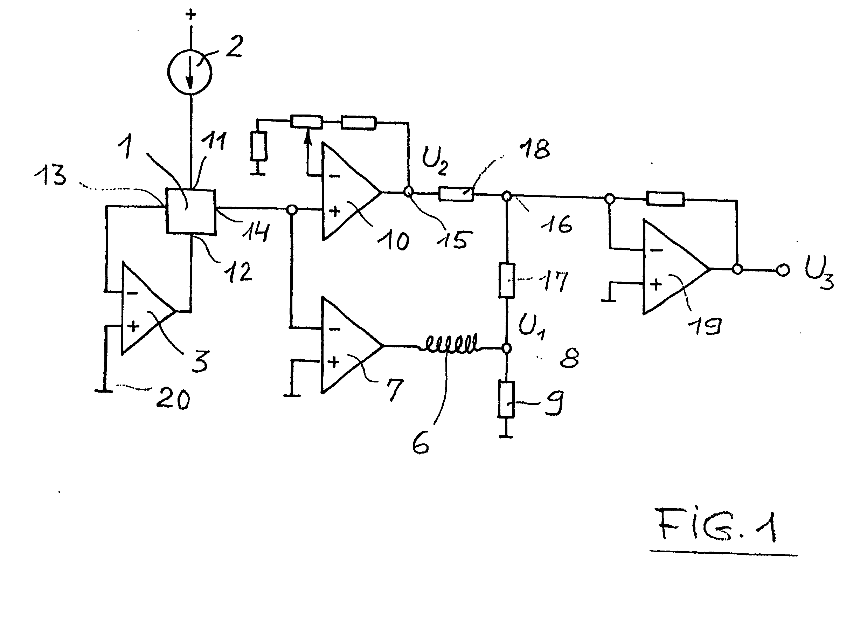

Le schéma de la Fig. 1 montre une cellule de Hall 1, connectée par une première borne d'alimentation 11 à une source de courant 2 et, par sa seconde borne d'alimentation 12, à la sortie d'un amplificateur 3 ayant des entrées +, - connectées respectivement à un potentiel de référence, soit dans le présent cas la masse, et à une première borne de sortie 13 de la cellule 1. Ainsi, cette borne 13 est maintenue au potentiel de la masse et la seconde borne de sortie 14 de la cellule 1 fait apparaître le signal fourni par la cellule comme tension par rapport à la masse.

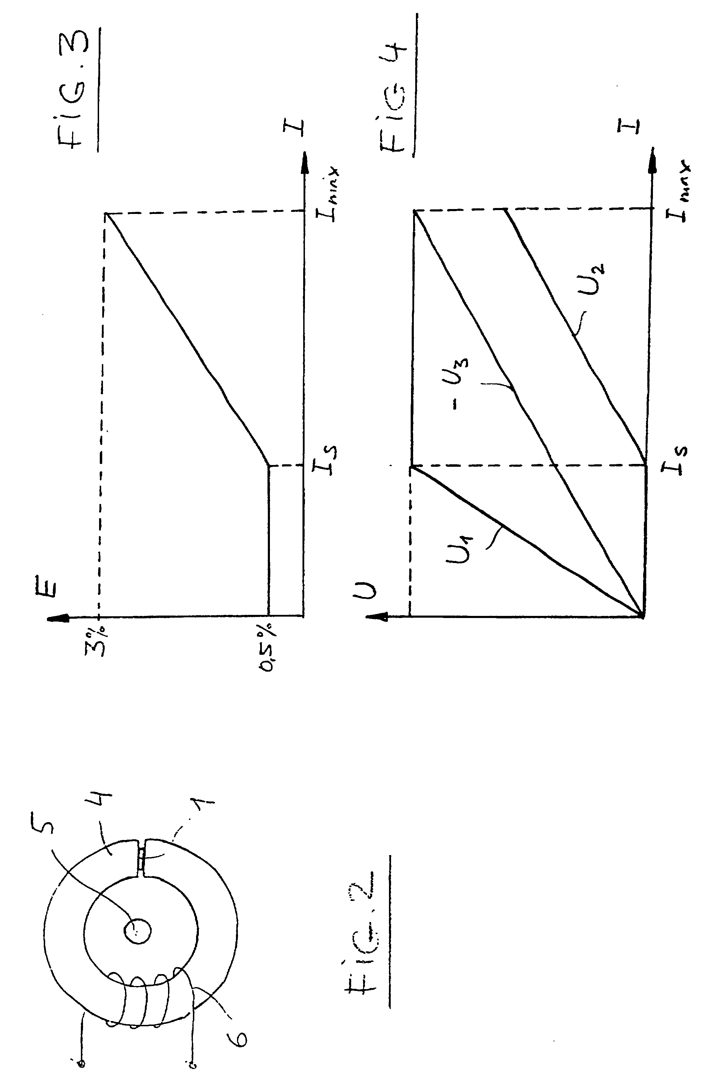

La cellule 1 est placée dans l'entrefer d'un circuit magnétique 4 représenté schématiquement à la Fig. 2. Ce circuit est agencé de façon à pouvoir être couplé avec un conducteur 5 dans lequel passe le courant à mesurer, et il porte un bobinage 6 servant, de manière connue, à fournir les ampères-tours nécessaires pour compenser le champ magnétique engendré par le courant à mesurer. A cet effet, comme le montre la Fig. 1, le bobinage 6 est connecté à la sortie d'un amplificateur 7 qui est commandé par le signal de sortie de la cellule de Hall 1 et qui fournit au bobinage 6 le courant nécessaire pour que le champ magnétique mesuré par la cellule de Hall devienne nul.

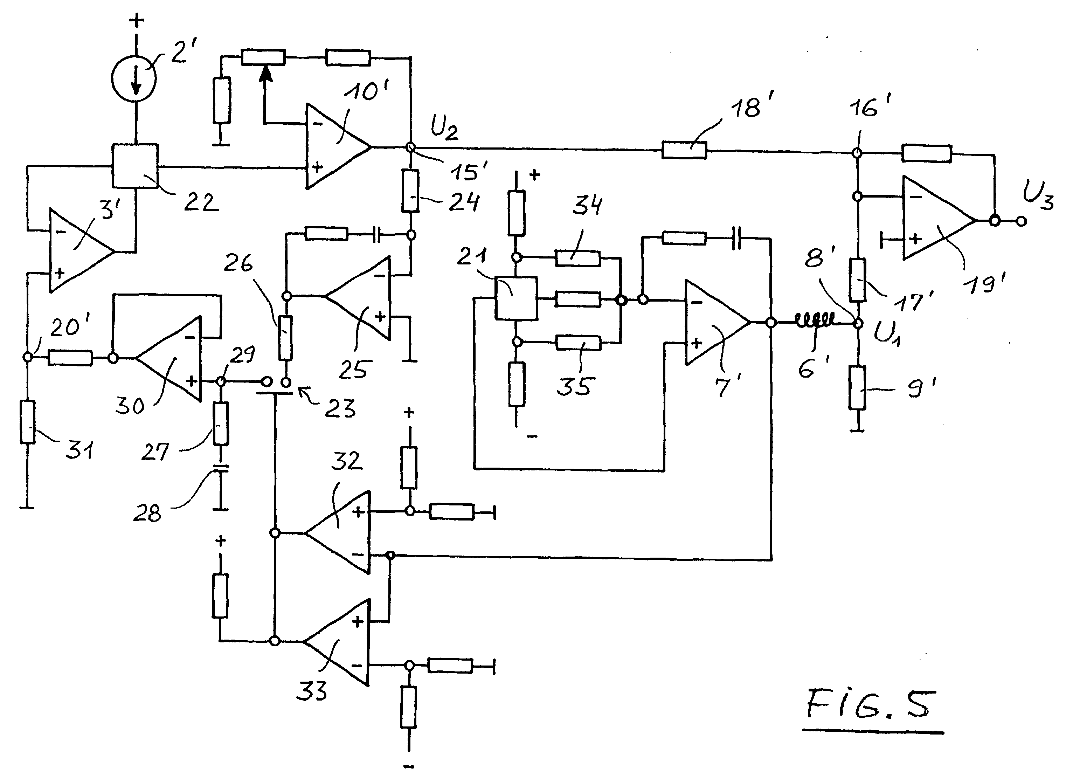

La tension apparaissant à une borne 8 d'une résistance 9 branchée entre le bobinage 6 et la masse, constitue un premier signal de mesure U₁ fonction du courant à mesurer I selon le graphique de la Fig. 4. La précision de cette mesure est élevée, l'erreur E maximale étant par exemple égale à 0,5 %, comme le représente le graphique de la Fig. 3. Ce premier circuit de mesure comprenant l'amplificateur 7 est dimensionné de façon à arriver à la saturation électrique pour une valeur I_{S} du courant à mesurer, cette valeur étant sensiblement inférieure à la valeur maximale Iₘₐₓ de ce courant. Dès que la saturation est atteinte, un signal de sortie différent de zéro va apparaître à la borne 14 et produira, à la sortie 15 d'un amplificateur à gain réglable 10 à l'entrée duquel il est appliqué, une tension de mesure U₂ proportionnelle à la valeur du courant I.

Les deux signaux de mesure U₁ et U₂ sont additionnés à la borne 16 par l'intermédiaire de résistances 17, 18 choisies de façon que le signal de mesure global résultant U₃ apparaissant à la sortie d'un amplificateur 19 soit continu pour toute la gamme de mesure, comme le montre le graphique de la Fig. 4. Si la précision de la mesure fournissant le signal U₂ n'est que de 4 % par exemple et la précision du signal de mesure U₁ est de 0,5 %, la précision du signal résultant U₃ sera de 0,5 % pour les courants inférieurs à I_{S} et va diminuer lorsque le courant augmente, l'erreur maximale atteignant environ 3 %, comme le montre la Fig. 3.

Dans de nombreuses applications dans lesquelles une précision élevée n'est exigée que pour des courants relativement faibles par rapport au courant maximal de la gamme de mesure, le présent dispositif permet de réaliser une économie importante par la limitation des ampères-tours à fournir pour la mesure par compensation.

La précision d'ensemble d'un tel dispositif à deux circuits de mesure peut en outre être améliorée sensiblement par un agencement tel que montré à la Fig. 5.

Dans la forme d'exécution selon la Fig. 5, deux cellules de Hall 21 et 22 sont placées dans le circuit magnétique, soit dans un entrefer constant, soit par exemple dans un entrefer ayant des hauteurs adaptées à l'épaisseur de chacune des cellules utilisées. En effet, on utilise dans le premier circuit de mesure du dispositif selon la Fig. 5, une cellule 21 d'un type présentant une faible erreur d'offset, par exemple du type IₙS_{b}, mais dont la variation du gain est importante tout en n'étant pas gênante et, en revanche, on choisit pour le second circuit de mesure une cellule de Hall 22 d'un type à faible variation du gain avec la température, par exemple une cellule au GaAs, en acceptant une erreur d'offset plus grande.

Le but du dispositif de la Fig. 5 est de réaliser, pendant les périodes de mesure pendant lesquelles le premier circuit de mesure n'est pas saturé, une compensation de l'erreur d'offset dans le second circuit de mesure et de maintenir cet état de compensation pendant la période pendant laquelle ce second circuit est opérationnel, c'est-à-dire pendant que le premier circuit est saturé.

Le fonctionnement des premier et second circuits de mesure avec addition des signaux U₁ et U₂ pour former le signal de mesure résultant U₃ est similaire à celui décrit en rapport avec la Fig. 1. Aussi, les éléments de la Fig. 1 se retrouvant dans le schéma de la Fig. 5 ont été désignés par le même chiffre de référence marqué d'un signe prime (').

Le dispositif de la Fig. 5 comporte dans le second circuit de mesure un circuit de modification du potentiel de référence au point 20', de telle façon que la tension apparaissant à la sortie 15' soit réduite à zéro pendant les périodes pendant lesquelles le premier circuit de mesure n'est pas saturé. Ces périodes se traduisent de manière décrite plus loin, par la fermeture d'un interrupteur 23.

Tant que le premier circuit de mesure 21, 7', 6', 9' n'est pas saturé, le signal U₂ doit être nul puisque le champ magnétique dans l'entrefer (dans lequel est logée la cellule de Hall 22) est annulé par compensation des ampères-tours engendrés respectivement par le courant à mesurer et par le bobinage 6'.

Si une tension par rapport à la masse apparaît au point 15' durant cette période, elle est donc due à un décalage dans le second circuit de mesure. Une telle tension d'offset est amenée via une résistance 24 à une entrée d'un amplificateur 25, dont une autre entrée est connectée à la masse, et elle produit, à l'état fermé de l'interrupteur 23, via des résistances 26 et 27, la charge d'un condensateur 28. La tension sur l'ensemble 27, 28 est appliquée à la borne d'entrée 29 à très haute impédance d'un amplificateur 30, la sortie duquel alimente un diviseur résistif connecté à la masse et dont le point intermédiaire 20' devient un point de référence variable pour l'entrée + de l'amplificateur 3'. Le circuit de correction ainsi formé entre les bornes 15' et 20', et la résistance 31 sont dimensionnés de façon à amener la tension à la borne 15' à zéro. On compense ainsi pendant les périodes pendant lesquelles le champ magnétique agissant sur la cellule 22 est nul, les tensions d'offset se produisant dans la cellule 22 et les amplificateurs 10', 30 et 3'.

Lorsque le premier circuit de mesure arrive à l'état de saturation, l'interrupteur 23 s'ouvre pour permettre au condensateur 28 de maintenir le potentiel existant à ses bornes et d'assurer ainsi le maintien de la compensation des tensions d'offset dans le second circuit de mesure. La constante de temps du circuit de décharge du condensateur 28 est choisie de façon à assurer la compensation pendant toute la période de fonctionnement du second circuit de mesure.

La Fig. 5 montre également un circuit d'actionnement de l'interrupteur 23 à partir de la tension de sortie de l'amplificateur 7'. Cette tension est appliquée à deux comparateurs 32, 33 qui la comparent à des tensions de références positive et négative proches des tensions positive et négative de saturation de l'amplificateur 7'. Lorsque la tension de sortie de 7' dépasse l'une de ces tensions de référence, le comparateur correspondant actionne l'interrupteur 23 qui est par exemple du type "analog switch". La cellule de Hall 21, qui peut être du type InSb, présente une erreur d'offset relativement faible en cours de fonctionnement, le décalage du circuit de mesure correspondant étant annulé à l'origine par le choix d'une résistance de compensation 34 ou 35 visible à la Fig. 5.

## Revendications

1. Dispositif capteur de courant pour la mesure du courant électrique passant dans un conducteur (5), ce dispositif comportant
un circuit magnétique (4) à entrefer agencé pour pouvoir être couplé avec ledit conducteur pour le courant à mesurer (I),
un détecteur de champ magnétique (1) disposé dans l'entrefer de ce circuit,
un bobinage (6) monté sur ce circuit magnétique,
un premier circuit électrique de mesure (1, 7, 6, 9) comprenant ledit bobinage (6),
des moyens (7) pour faire passer dans ce bobinage, sous la commande du détecteur de champ magnétique, un courant de compensation tendant à annuler le champ produit dans l'entrefer par le courant à mesurer,
des moyens (9) pour fournir un premier signal de mesure (U₁) fonction dudit courant de compensation, et
un second circuit électrique de mesure (1, 10) agencé pour fournir un second signal de mesure (U₂) fonction du champ magnétique détecté dans l'entrefer,
**caractérisé en ce que** le premier circuit de mesure est dimensionné de façon à être saturé électriquement à une valeur du courant de compensation correspondant à un courant à mesurer (I_{S}) sensiblement inférieur au courant maximum à mesurer (Iₘₐₓ).

2. Dispositif selon la revendication 1, **caractérisé en ce qu'**il comporte des moyens pour additionner les premier et second signaux de mesure de façon à produire un signal de mesure résultant (U₃), dont la variation avec le courant à mesurer est continue dans toute la gamme de mesure.

3. Dispositif selon l'une des revendications 1 ou 2, **caractérisé en ce que** le premier circuit de mesure est commandé par un premier détecteur de champ magnétique (21) présentant une erreur d'offset relativement faible, **en ce que** le second circuit de mesure comprend un second détecteur de champ magnétique (22) présentant une variation de gain relativement faible, et **en ce qu'**il comporte des moyens (24 à 31) pour annuler le signal de sortie du second circuit de mesure tant que le premier circuit de mesure n'est pas saturé, de façon à compenser l'erreur d'offset du second circuit de mesure, ainsi que des moyens (23, 28) pour maintenir cette compensation dans le second circuit de mesure durant la période, durant laquelle le premier circuit de mesure est électriquement saturé.

4. Dispositif selon l'une des revendications précédentes, **caractérisé en ce que** les détecteurs de champ magnétique sont des cellules de Hall.

## Claims

1. Current sensor for measuring the electric current flowing in a conductor (5), this device comprising
a magnetic circuit (4) with air gap, arranged so that it can be coupled with said conductor for the current (I) to be measured,
a magnetic field detector (1) arranged in the air gap of this circuit,
a coil (6) wound on this magnetic circuit,
a first electrical measuring circuit (1, 7, 6, 9) comprising said coil (6),
means (7) to send a compensating current tending to cancel the field generated in the air gap by the current to be measured, through this coil under control of the magnetic field detector,
means (9) to supply a first measured signal (U₁) which is a function of said compensating current, and
a second electrical measuring circuit (1, 10) arranged so as to supply a second measured signal (U₂) which is a function of the magnetic field detected in the air gap,
**characterized in that** the first measuring circuit is dimensioned so as to be electrically saturated at a value of the compensating current that corresponds to a current (I_{S}) to be measured that is appreciably smaller than the largest current (Iₘₐₓ) to be measured.

2. Device according to claim 1, **characterized in that** it comprises means for adding the first and second measured signals so as to produce a resulting measured signal (U₃) varying smoothly with the current to be measured over the entire measuring range.

3. Device according to any of claims 1 or 2, **characterized in that** the first measuring circuit is controlled by a first magnetic field detector (21) having a relatively low offset error, **in that** the second measuring circuit contains a second magnetic field detector (22) having a relatively small gain variation, and **in that** it comprises means (24 to 31) to cancel the output signal of the second measuring circuit so long as the first measuring circuit is not saturated, so as to compensate the offset error of the second measuring circuit, as well as means (23, 28) to maintain this compensation in the second measuring circuit during the period during which the first measuring circuit is electrically saturated.

4. Device according to any of the preceding claims, **characterized in that** the magnetic field detectors are Hall cells.

## Patentansprüche

1. Strommessfühler zur Messung des in einem Leiter (5) fliessenden elektrischen Stromes, wobei diese Vorrichtung
einen magnetischen Kreis (4) mit Luftspalt, der so eingerichtet ist, dass er mit diesem Leiter für den zu messenden Strom (I) gekoppelt werden kann,
einen Magnetfelddetektor (1), der im Luftspalt dieses Kreises angeordnet ist,
eine auf diesen magnetischen Kreis gewickelte Spule (6),
einen ersten elektrischen Messkreis (1, 7, 6, 9), der diese Spule (6) enthält,
Mittel (7), um gesteuert vom Magnetfelddetektor einen Kompensationsstrom durch diese Spule zu schicken, der das im Luftspalt durch den zu messenden Strom erzeugte Feld aufzuheben sucht,
Mittel (9), um ein erstes Messsignal (U₁) zu liefern, das eine Funktion dieses Kompensationsstromes ist, und
einen zweiten elektrischen Messkreis (1, 10) umfasst, der so eingerichtet ist, dass er ein zweites Messsignal (U₂) liefert, das eine Funktion des im Luftspalt nachgewiesenen Magnetfeldes ist,
**dadurch gekennzeichnet, dass** der erste Messkreis so bemessen ist, dass er bei einem Wert des Kompensationsstromes elektrisch gesättigt ist, der einem zu messenden Strom (I_{S}) entspricht, der spürbar kleiner als der grösste zu messende Strom (Iₘₐₓ) ist.

2. Vorrichtung gemäss Anspruch 1, **dadurch gekennzeichnet, dass** sie Mittel enthält, um das erste und zweite Messsignal so zu addieren, dass ein resultierendes Messsignal (U₃) erzeugt wird, dessen Veränderung mit dem zu messenden Strom über den ganzen Messbereich stetig ist.

3. Vorrichtung nach einem der Ansprüche 1 oder 2, **dadurch gekennzeichnet, dass** der erste Messkreis durch einen ersten Magnetfelddetektor (21 ) gesteuert wird, der einen verhältnismässig geringen Offsetfehler aufweist, dadurch, dass der zweite Messkreis einen zweiten Magnetfelddetektor (22) enthält, der eine verhältnismässig geringe Veränderung der Verstärkung aufweist, und dadurch, dass die Vorrichtung Mittel (24 bis 31) enthält, um das Ausgangssignal des zweiten Messkreises zu unterdrücken, solange der erste Messkreis nicht gesättigt ist, so dass der Offsetfehler des zweiten Messkreises kompensiert wird, sowie Mittel (23, 28), um diese Kompensation im zweiten Messkreis in der Zeit aufrechtzuerhalten, während der der erste Messkreis elektrisch gesättigt ist.

4. Vorrichtung gemäss einem der vorangehenden Ansprüche, **dadurch gekennzeichnet, dass** die Magnetfelddetektoren Hallsonden sind.
